# EUROPEAN PATENT SPECIFICATION

(11) **EP 3 648 177 B1**
(45) Date of publication and mention of the grant of the patent: **15.03.2023**
(21) Application number: 19206527.4
(22) Date of filing: 31.10.2019
(51) Int. Cl.: H01L 31/048, H01L 31/05

(54) **SOLAR CELL PANEL AND METHOD FOR MANUFACTURING THE SAME**
SOLARZELLENTAFEL UND VERFAHREN ZUR HERSTELLUNG DAVON
PANNEAU DE CELLULE SOLAIRE ET SON PROCÉDÉ DE FABRICATION

(30) Priority: 03.11.2018 KR 20180134024
(43) Date of publication of application: 06.05.2020
(73) Proprietor: LG Electronics Inc., SEOUL, 07336 (KR)
(72) Inventor: KIM, Juseok, 08592 Seoul (KR); MUN, Seiyoung, 08592 Seoul (KR); PARK, Sanghwan, 08592 Seoul (KR); LEE, Jongha, 08592 Seoul (KR)
(74) Representative: Katérle, Axel

(56) References cited:
- JP-A- 2005 079 170
- JP-A- 2009 246 208
- US-A1- 2012 152 328
- US-A1- 2015 075 591
- US-A1- 2015 155 412
- US-A1- 2017 012 146
- US-A1- 2017 179 319

## Description

### BACKGROUND OF THE INVENTION

### Field of the Invention

Embodiments of the invention relate to a method for manufacturing a solar cell panel, and more particularly, to a method for manufacturing a solar cell panel having improved structure.

### Description of the Related Art

A plurality of solar cells are connected by ribbons, interconnectors, and the like, and are manufactured as solar cell panels protected by sealing members and cover members. As a result, the solar cell panels can have desired outputs and can be safely protected even when exposed to an external environment for a long period of time.

The solar cell panels including the various members are integrated by a lamination process for applying heat and pressure. A part that receives a large load due to the pressure applied during the lamination process can have characteristics different from those of other parts. Accordingly, when the solar cell panels are used for a long time, unwanted problems could occur in the part that receives the large load. These problems can occur even more when the cover members constituting both outer surfaces of the solar panel are composed of a glass substrate and relatively high pressure is applied in the lamination process.

For example, in the case where each of the cover members forming the both outer surfaces of the solar cell panel is composed of a glass substrate, the thickness of the sealing members at the edges of the solar cell panel is reduced by the weight of the cover member during the lamination process. In particular, the thickness of the sealing members can be reduced at the part where the bus ribbon extends to the outside for connection with the outside. When a thermal cycle test in which the temperature is repeatedly changed in the solar cell panel is performed, the solar cell can be damaged where the bus ribbon is positioned. This problem can occur when the thickness of ribbons, interconnectors, etc. connecting the solar cells is relatively large compared to the width.

JP 2009 246208 A discloses a method for manufacturing a solar cell module including forming a stacked structure comprising a first translucent cover member (e.g., a glass substrate); a first sealing layer, laminated on the translucent substrate; a first horizontal sealing layer; a second horizontal sealing layer; a plurality of solar cells, arranged in a matrix and connected via a plurality of wiring members; a bus ribbon part; a second sealing layer, laminated on the horizontal wiring sealing layer; and a second cover member, laminated on the second sealing layer. The stacked structure is laminated by applying heat and pressure.

### SUMMARY OF THE INVENTION

An object of the present invention is to provide a method for manufacturing a solar cell panel capable of improving long-term reliability with a simple structure.

In particular, the present invention is intended to provide a method for manufacturing a solar cell panel capable of preventing damage, etc. of wiring members which can occur when a front cover member and a back cover member are composed of a glass substrate and the wiring members having a relatively large thickness compared to its width or a circular shape or a rounded shape are used.

A solar cell panel includes a solar cell string including a plurality of solar cells and a plurality of wiring members connecting the plurality of solar cells in one direction; a bus ribbon part including a bus ribbon connected to the solar cell string and extending outwards toward a periphery of the solar cell panel; a sealing member surrounding the solar cell string by including a first sealing member positioned on one surface of the solar cell string and a second sealing member positioned on other surface of the solar cell string; a first cover member positioned on the one surface of the solar cell string on the first sealing member; and a second cover member positioned on the other surface of the solar cell string on the second sealing member. The first sealing member includes an additional sealing part having a thicker thickness than other part or a higher density than the other part in a part corresponding to the bus ribbon part.

The bus ribbon part is positioned to overlap at least a part of the solar cell string, and an insulating member is provided between the solar cell string and the bus ribbon part to insulate. A sealing member disposed opposite to the insulating member has the additional sealing part.

The additional sealing part can be positioned to include entirely at least a part in which the bus ribbon part is positioned in the solar cell panel and can be formed partially in the solar cell panel.

A ratio of a width of the additional sealing part to a width of the bus ribbon part can be 1 to 1.5, and a ratio of a length of the additional sealing part to a length of the bus ribbon part can be 1 to 1.5.

The additional sealing part can be positioned to be spaced apart from an edge of the solar cell panel.

A first width of the wiring member can be 250um to 500um, or the wiring member can include a circle or rounded part.

The first and second cover members each includes a glass substrate.

A thickness of the sealing member positioned on one side of the solar cell can be two times or less with respect to a width or a diameter of the wiring member.

A method for manufacturing a solar cell panel according to an embodiment of the present invention includes the features of claim 1. A method for manufacturing a solar cell panel may include: forming a stacked structure by stacking a first cover member; a first main sealing member; a solar cell string including a plurality of solar cells and a plurality of wiring members connecting the plurality of solar cells in one direction; a bus ribbon part including a bus ribbon connected to the solar cell string and extending outwards toward a periphery of the solar cell panel; a second main sealing member; and a second cover member; and laminating by applying heat and pressure to the stacked structure. An additional sealing member is further positioned in a part corresponding to the bus ribbon part between the first cover member and the second cover member in the forming the laminate structure.

The bus ribbon part is positioned to overlap at least a part of the solar cell string, and an insulating member is provided between the solar cell string and the bus ribbon part to insulate. The additional sealing member is positioned opposite to the insulating member in the solar cell string.

A ratio of a thickness of the additional sealing member to a thickness of the first or second main sealing member can be 0.4 to 1.5 times.

A thickness of the additional sealing member can be equal to, greater than or less than a thickness of the first or second main sealing member.

A thickness of the additional sealing member can be approximately 250 µm to 600 µm.

According to the present embodiment, it is possible to effectively prevent damage to the solar cell and the like that can occur at the edges of the solar cell panel in which the bus ribbon part is positioned by a simple structure using the additional sealing member. Thus, a long-term reliability of the solar cell panel can be improved while manufacturing the solar cell panel by a simple process. At this time, since the additional sealing member is partially provided corresponding to the bus ribbon part, the cost can be effectively reduced. This effect can be especially doubled in a structure in which the thickness of the sealing member is below a certain level, the wiring member has a relatively large thickness as compared with the width, or the wiring member has a circular shape or a rounded shape, or the first and second cover members each include a glass substrate.

### BRIEF DESCRIPTION OF THE DRAWINGS

FIG. 1 is a perspective view illustrating a solar cell panel according to an embodiment of the present invention.
FIG. 2 is a cross-sectional view taken along a line II-II in FIG. 1.
FIG. 3 is a partial cross-sectional view illustrating a solar cell and a wiring member connected thereto which are included in a solar cell panel shown in FIG. 1.
FIG. 4 is a perspective view schematically illustrating two neighboring solar cells which are included in a solar cell panel shown in FIG. 1 and connected by a wiring member.
FIG. 5 is a front plan view of a solar cell included in a solar cell panel shown in FIG. 1.
FIG. 6 is a back plan view schematically illustrating a solar cell panel included in FIG. 1.
FIG. 7 is a partial cross-sectional view of a solar cell panel showing an enlarged part of a solar cell panel shown in FIG. 1.
FIG. 8 is a partial cross-sectional view of a solar cell panel showing an enlarged part of a solar cell panel according to a modification of the present invention.
FIG. 9 is a back plan view schematically illustrating a solar cell panel according to another modification of the present invention.
FIG. 10 is a back plan view schematically illustrating a solar cell panel according to other modification of the present invention.
FIGS. 11A to 11C are views schematically illustrating a method for manufacturing a solar cell panel according to an embodiment of the present invention.
FIG. 12 is a photographic image of a solar cell panel including a sealing member having an additional sealing part or an additional sealing member according to an embodiment of the present invention.
FIG. 13 is a photographic image of a solar cell panel according to a comparative example including a sealing member that does not include an additional sealing part or an additional sealing member.

### DETAILED DESCRIPTION OF THE EMBODIMENTS

Hereinafter, embodiments of the present invention will be described in detail with reference to the accompanying drawings. However, it is needless to say that the present invention is not limited to these embodiments and can be modified into various forms.

In the drawings, illustration of the parts not related to the description is omitted in order to describe one or more embodiments of the present invention with clarity and brevity, and the same reference numerals are used for the same or very similar parts throughout the specification. In the drawings, the thickness, width, and the like are enlarged or reduced to make the explanation more clear, and the thickness, width, etc. of the present invention are not limited to those shown in the drawings.

When a part is referred to as "including" another part throughout the specification, it does not exclude other parts and can further include other parts unless specifically stated otherwise. Further, when a part of a layer, a film, a region, a plate, or the like is referred to as being "on" other part, this includes not only the case where it is "directly on" the other part but also the case where the other part is positioned in the middle. When the part of the layer, the film, the region, the plate, or the like is referred to as being "directly on" the other part, it means that no other part is positioned in the middle.

Hereinafter, a solar cell and a solar cell panel including the solar cell according to an embodiment of the present invention will be described in detail with reference to the accompanying drawings. In the following, the expressions "first", "second", "third", etc. are used only to distinguish each other, but the present invention is not limited thereto.

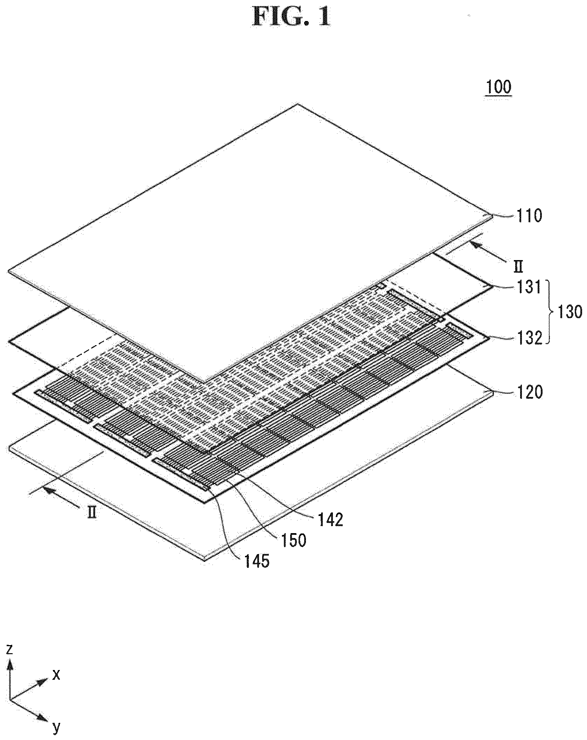

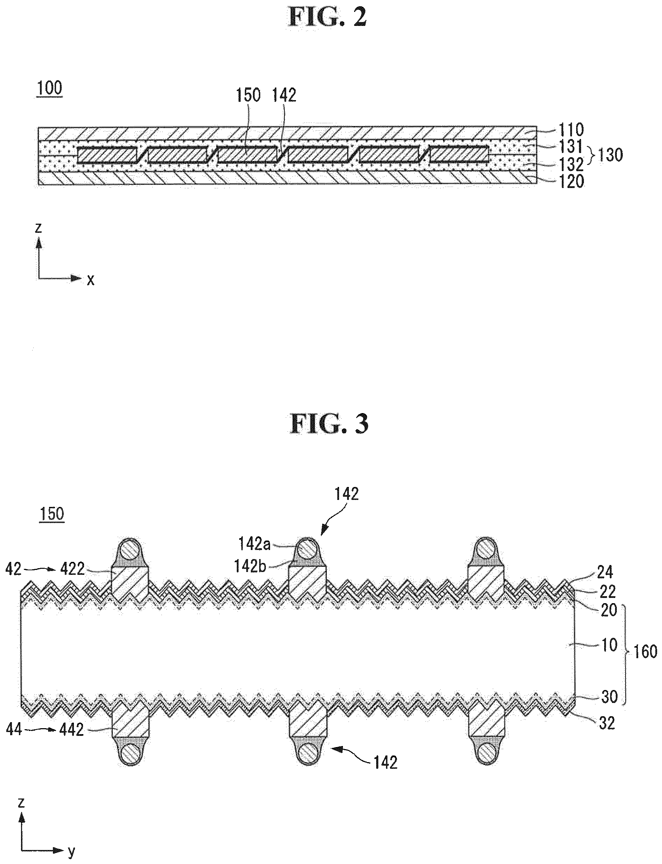

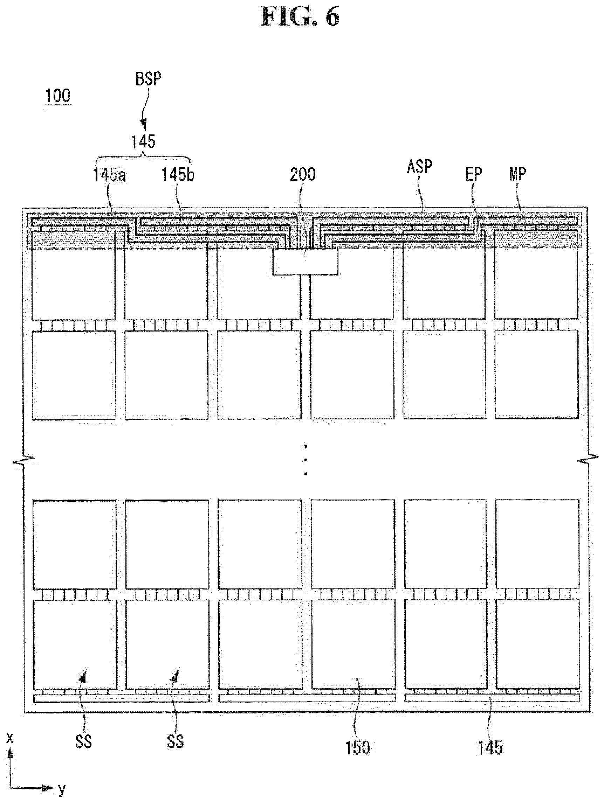

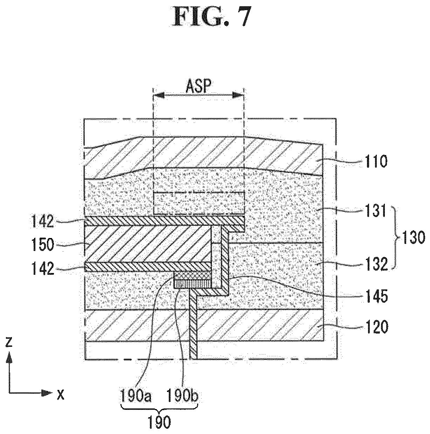

FIG. 1 is a perspective view illustrating a solar cell panel according to an embodiment of the present invention, and FIG. 2 is a cross-sectional view taken along a line II-II in FIG. 1. For reference, FIG. 1 schematically illustrates a bus ribbon 145 and a connection structure thereof for understanding, and in FIG. 2, an illustration of the bus ribbon 145 and the connection structure thereof is omitted. A detailed structure of the bus ribbon 145 and the connection structure thereof are illustrated in FIGS. 6 and 7, and the bus ribbon 145 and the connection structure thereof will be described in detail later with reference to FIGS. 6 and 7.

Referring to FIGS. 1 and 2, a solar cell panel 100 according to the present embodiment includes a plurality of solar cells 150 and a wiring member (or a wire, an interconnector, etc.) 142 for electrically connecting the plurality of solar cells 150. The solar cell panel 100 includes a sealing member 130 that surrounds and seals the plurality of solar cells 150 and the wiring member (or interconnector) 142 connecting thereto, a first cover member 110 positioned on a front surface of the solar cell 150 on the sealing member 130, and a second cover member 120 positioned on a back surface of the solar cell 150 on the sealing member 130. This will be explained in more detail.

First, the solar cell 150 can include a photoelectric conversion unit that converts the solar cell into electric energy, and an electrode that is electrically connected to the photoelectric conversion unit to collects and transfers a current. The plurality of solar cells 150 can be electrically connected in series, parallel, or series-parallel by the wiring member 142. Specifically, the wiring member 142 electrically connects two neighboring solar cells 150 among the plurality of solar cells 150.

A bus ribbon 145 alternately connects two ends of the wiring member 142 of the solar cell 150 (i.e., the solar cell string) connected by the wiring member 142 to form one row. The bus ribbon 145 can be positioned at an end of the solar cell string in a direction intersecting the end. This bus ribbon 145 can connect the solar cell strings adjacent to each other, or can connect the solar cell string to a junction box (not shown) that prevents reverse flow of the current. The material, shape, connection structure, etc. of the bus ribbon 145 can be variously modified, and the present invention is not limited thereto.

The sealing member 130 can include a first sealing member 131 positioned on the front surface of the solar cell 150 connected by the wiring member 142, and a second sealing member 132 positioned on the back surface of the solar cell 150. The first sealing member 131 and the second sealing member 132 prevent moisture and oxygen from entering and chemically bind each element of the solar cell panel 100. The first and second sealing members 131 and 132 can be made of an insulating material having transparency and adhesiveness. For example, an ethylene-vinyl acetate copolymer resin (EVA), a polyvinyl butyral, a silicon resin, an ester-based resin, an olefin-based resin, or the like can be used for the first sealing member 131 and the second sealing member 132. The second cover member 120, the second sealing member 132, the solar cell 150, the first sealing member 131, and the first cover member 110 are integrated to form the solar cell panel 100 by a lamination process or the like using the first and second sealing members 131 and 132.

The first cover member 110 is positioned on the first sealing member 131 to constitute the front surface of the solar cell panel 100, and the second cover member 120 is positioned on the second sealing member 132 to constitute the back surface of the solar cell panel 100. The first cover member 110 and the second cover member 120 can be made of an insulating material capable of protecting the solar cell 150 from external shock, moisture, ultraviolet rays, or the like. The first cover member 110 can be made of a light transmissive material through which light can pass, and the second cover member 120 can be made of a sheet composed of a light transmissive material, a non-light transmissive material, or a reflective material. For example, the first cover member 110 can be composed of a glass substrate or the like, and the second cover member 120 can have a TPT (Tedlar/PET/Tedlar) type, or include a polyvinylidene fluoride (PVDF) resin layer formed on at least one surface of a base film (for example, polyethylene terephthalate (PET)).

However, the present invention is not limited thereto. Accordingly, the first and second sealing members 131 and 132, the first cover member 110, or the second cover member 120 can include various materials other than those described above, and can have various shapes. For example, the first cover member 110 or the second cover member 120 can have various shapes (for example, a substrate, a film, a sheet, etc.) or materials.

The solar cell 150 and the wiring member 142 connected thereto according to the embodiment of the present invention will be described in more detail with reference to FIG. 3. FIG. 3 is a partial cross-sectional view illustrating the solar cell 150 and the wiring member 142 connected thereto which are included in the solar cell panel 100 shown in FIG. 1. For simplicity, electrodes 42 and 44 are schematically shown in FIG. 3.

Referring to FIG. 3, the solar cell 150 includes a semiconductor substrate 160, conductive type regions 20 and 30 formed at or on the semiconductor substrate 160, and electrodes 42 and 44 connected to the conductive type regions 20 and 30. The conductive type regions 20 and 30 can include a first conductive type region 20 having a first conductive type and a second conductive type region 30 having a second conductive type. The electrodes 42 and 44 can include a first electrode 42 connected to the first conductive type region 20 and a second electrode 44 connected to the second conductive type region 30. Furthermore, the solar cell 150 can further include first and second passivation layers 22 and 32, an anti-reflection layer 24, and the like.

The semiconductor substrate 160 can be composed of a crystalline semiconductor (for example, a single crystal or polycrystalline semiconductor, for example, a single crystal or polycrystalline silicon) including a single semiconductor material (for example, a group 4 element). Then, since the semiconductor substrate 160 having a high degree of crystallinity and having few defects is used as a base, the solar cell 150 can have excellent electrical characteristics.

The front surface and/or the back surface of the semiconductor substrate 160 can be textured to have unevenness. The unevenness can have, for example, a pyramid shape having an irregular size, whose outer surface is composed of the plane (111) of the semiconductor substrate 160. As a result, the reflectance of light can be reduced if having a relatively large surface roughness. However, the present invention is not limited thereto.

In the present embodiment, the semiconductor substrate 160 includes a base region 10 having the first or second conductive type by doping a first or second conductive type dopant with a lower doping concentration than the first or second conductive type region 20, 30. As an example, the base region 10 can have the second conductive type in the present embodiment.

As an example, the first conductive type region 20 can compose or provide an emitter region that forms a p-n junction with the base region 10. The second conductive type region 30 can form a back surface field to form a back field region for preventing recombination. Here, the first and second conductive type regions 20 and 30 can be formed as a whole on the front surface and the back surface of the semiconductor substrate 160. Thus, the first and second conductive type regions 20 and 30 can be formed with a sufficient area without additional patterning. However, the present invention is not limited thereto.

In the present embodiment, the base region 10 and the conductive type regions 20 and 30 composing the semiconductor substrate 160 are exemplified as regions having a crystal structure of the semiconductor substrate 160 and different conductive type, different doping concentration, etc. That is, it is illustrated that the conductive type regions 20 and 30 are doped regions constituting a part of the semiconductor substrate 160. However, the present invention is not limited thereto. Therefore, at least one of the first conductive type region 20 and the second conductive type region 30 can be formed of an amorphous, microcrystalline or polycrystalline semiconductor layer or the like, which is formed on the semiconductor substrate 160 as a separate layer. Other variations are possible.

The first conductive type dopant included in the first conductive type region 20 can be an n-type or p-type dopant, and the second conductive type dopant included in the base region 10 and the second conductive type region 30 can be a p-type or n-type dopant. Group 3 elements such as boron (B), aluminum (Al), gallium (Ga), or indium (In) can be used as the p-type dopant, and group 5 elements such as phosphorus (P), arsenic (As), bismuth (Bi), and antimony (Sb) can be used as the n-type dopant. The second conductive type dopant in the base region 10 and the second conductive type dopant in the second conductive type region 30 can be the same material or different materials.

For example, the first conductive type region 20 can have a p-type, the base region 10 and the second conductive type region 30 can have an n-type. Then, holes having a slower moving speed than electrons can move to the front surface of the semiconductor substrate 160, rather than the back surface thereof, thereby improving the conversion efficiency. However, the present invention is not limited thereto, and the opposite case is also possible.

An insulating layer such as the first and second passivation layers 22 and 32 for immobilizing defects of the conductive type regions 20 and 30 and the anti-reflection layer 24 for preventing reflection of light can be formed on the surface of the semiconductor substrate 160. Such an insulating layer can be composed of an undoped insulating layer which does not contain a dopant separately. The first and second passivation layers 22 and 32 and the anti-reflection layer 24 can be formed substantially entirely on the front surface and back surface of the semiconductor substrate 160 except for parts (more precisely, parts where a first or second opening is formed, for example) corresponding to the first or second electrode 42, 44.

For example, the first or second passivation layer 22, 32 or the anti-reflection layer 24 can have a silicon nitride layer, a silicon nitride layer containing hydrogen, a silicon oxide layer, a silicon oxynitride layer, an aluminum oxide layer, any one single layer selected from a group consisting of MgF₂, ZnS, TiO₂ and CeO₂ or a multi-layered structure in which two or more layers are combined. For example, the first or second passivation layer 22 or 32 can include a silicon oxide layer, a silicon nitride layer, or the like having a fixed positive charge when the first or second conductive type region 20 or 30 has an n-type, and can include an aluminum oxide layer, or the like having a fixed negative charge when the first or second conductive type region 20 or 30 has a p-type. As one example, the anti-reflection layer 24 can include silicon nitride. In addition, the material of the insulating layer, the multi-layered structure, and the like can be variously modified.

The first electrode 42 is electrically connected to the first conductive type region 20 through a first opening and the second electrode 44 is electrically connected to the second conductive type region 30 through a second opening. The first and second electrodes 42 and 44 are made of various materials (for example, metal materials) and can be formed to have various shapes. The shape of the first and second electrodes 42 and 44 will be described later.

As described above, in the present embodiment, since the first and second electrodes 42 and 44 of the solar cell 150 have a certain pattern, the solar cell 150 has a bi-facial structure in which light can be incident on the front surface and the back surface of the semiconductor substrate 160. Accordingly, the amount of light used in the solar cell 150 can be increased to contribute to the efficiency improvement of the solar cell 150.

However, the present invention is not limited thereto, and it is also possible that the second electrode 44 is formed entirely on the back surface of the semiconductor substrate 160. It is also possible that the first and second conductive type regions 20 and 30 and the first and second electrodes 42 and 44 are positioned together on one surface (for example, the back surface) of the semiconductor substrate 160, and it is also possible that at least one of the first and second conductive type regions 20 and 30 is formed over both surface of the semiconductor substrate 160. That is, the solar cell 150 described above is merely an example, and the present invention is not limited thereto.

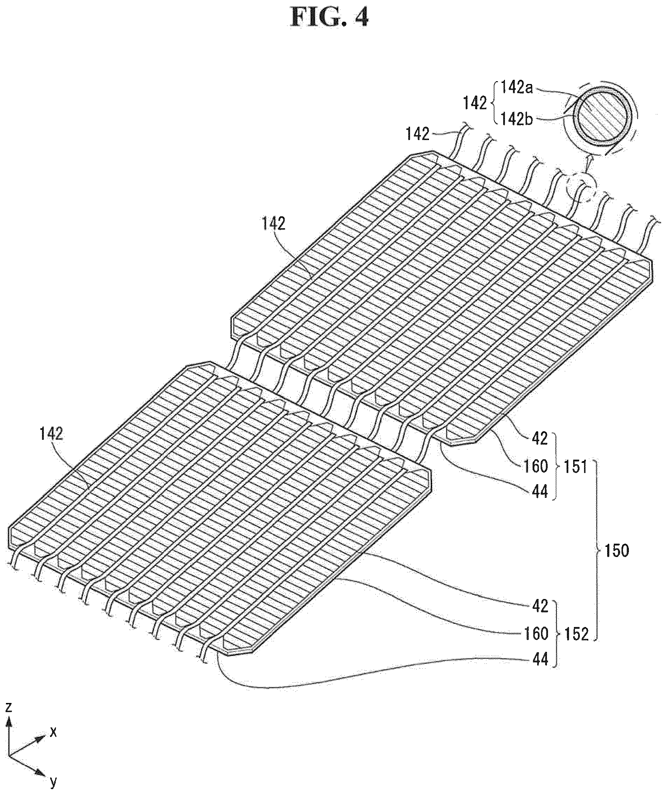

The solar cell 150 described above is electrically connected to the neighboring solar cell 150 by the wiring member 142 positioned (e.g., in contact with) on the first electrode 42 or the second electrode 44, and this will be described in more detail with reference to FIG. 4 together with FIG. 1 to FIG. 3.

FIG. 4 is a perspective view schematically illustrating two neighboring solar cells 151, 152 which are included in the solar cell panel 100 shown in FIG. 1 and connected by the wiring member 142. In FIG. 4, the two neighboring solar cells 151, 152 are schematically shown mainly on the semiconductor substrate 160 and the electrodes 42 and 44.

As shown in FIG. 4, the wiring member 142 connects the first electrode 42 positioned on a front surface of a first solar cell 151 and the second electrode 44 positioned on a back surface of a second solar cell 152 positioned at one side (lower left of the drawing) of the first solar cell 151. Another wiring member 142 connects the second electrode 44 positioned on a back surface of the first solar cell 151 and the first electrode 42 positioned on a front surface of another solar cell to be positioned on another side (upper right of the drawing) of the first solar cell 151. Other wiring member 142 connects the first electrode 42 positioned on a front surface of the second solar cell 152 and the second electrode 44 positioned on a back surface of other solar cell to be positioned at one side (lower left of the drawing) of the second solar cell 152. Accordingly, the plurality of solar cells 150 can be connected to each other by the wiring member 142 to form one row. Hereinafter, the description of the wiring member 142 can be applied to all the wiring member 142 connecting two neighboring solar cells 150.

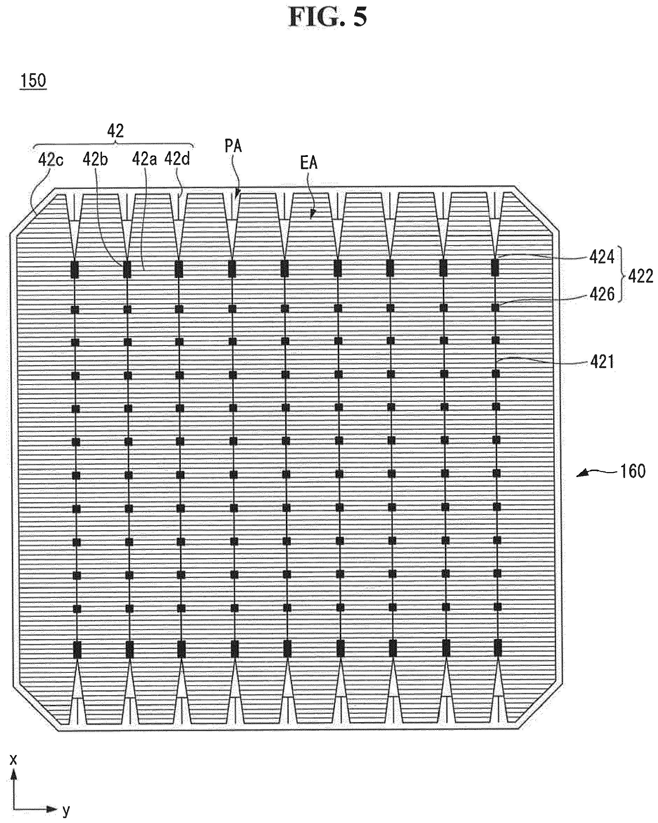

At this time, the plurality of wiring members 142 can be extended to be positioned along one direction (an x-axis direction in the drawing, a direction intersecting a first finger line (reference numeral 42a in FIG. 5, hereafter the same), or an extending direction of a first bus bar (reference numeral 42b in FIG. 5 hereafter the same)) on one surface of each solar cell 150 to improve electrical connection characteristics of neighboring solar cells 150.

In the present embodiment, the wiring member 142 can be formed of a wire having a width smaller than that of a ribbon having a relatively wide width (for example, more than 1 mm) which has been used conventionally. For example, a maximum width of the wiring member 142 can be 1 mm or less (for example, 500 *µ*m or less, hereinafter, more specifically, 250 µm to 500 µm, or approximately 250 µm to 500 µm). Here, the maximum width of the wiring member 142 can mean a largest width among widths passing the center of the wiring member 142. When the wiring member 142 has the maximum width described above, it can be smoothly attached to the solar cell 150 while keeping the resistance of the wiring member 142 low and minimizing the optical loss.

The number of the wiring members 142 can be greater than the number (for example, 2 to 5) of the conventional ribbons on the basis of one surface of each solar cell 150. Then, a movement distance of carriers can be reduced by a large number of the wiring members 142 while minimizing the optical loss and material cost by the wiring member 142 having a small width. Thus, the efficiency of the solar cell 150 and the output of the solar cell panel 100 can be improved by reducing the movement distance of the carriers while reducing the optical loss, and productivity of the solar cell panel 100 can be improved by reducing the material cost due to the wiring member 142.

In order to prevent the process of attaching the wiring member 142 to the solar cell 150 from becoming complicated when the number of the wiring member 142 having the small width is used in a large number, in the present embodiment, the wiring member 142 can have a structure including a core layer 142a and a solder layer 142b formed on the surface of the core layer 142a. Then, a large number of the wiring member 142 can be effectively attached by the process of applying heat and pressure in a state where the plurality of wiring member 142 is placed on the solar cell 150.

The wiring member 142 or the core layer 142a, which is included in the wiring member 142 and occupies most of the wiring member 142, can include rounded parts. That is, at least a part of the cross section of the wiring member 142 or the core layer 142a can include a circle, a part of a circle, an ellipse, a part of an ellipse, or a part made of a curve.

If it has such a shape, the wiring member 142 is formed in a structure in which the solder layer 142b is entirely positioned on the surface of the core layer 142a, the process of separately applying the solder material and the like are omitted, so that the wiring member 142 can be attached by positioning the wiring member 142 directly on the solar cell 150. Thus, the process of attaching the wiring member 142 can be simplified. In addition, light reflected by the wiring member 142 can be re-incident on the solar cell 150 and reused by being reflected or diffused by the rounded parts of the wiring member 142. Accordingly, since the amount of light incident on the solar cell 150 is increased, the efficiency of the solar cell 150 and the output of the solar cell panel 100 can be improved. However, the present invention is not limited thereto. Therefore, the wire constituting the wiring member 142 can have a polygonal shape such as a quadrangle, or can have various other shapes.

At this time, the number of the wiring members 142 can be 6 to 33 (for example, 8 to 33, for example, 10 to 33, particularly 10 to 15), and they can be spaced apart from each other at a uniform distance. The plurality of the wiring member 142 in each solar cell 150 can have a symmetrical shape when viewed in an extending direction of the first finger line 42a. Thus, a sufficient number of the wiring members 142 can be provided, and the movement distance of the carriers can be minimized.

In the present embodiment, the wiring member 142 can include the core layer 142a made of metals and the solder layer 142b that is formed on the surface of the core layer 142a and includes solder material to enable soldering with the electrodes 42,44. That is, the solder layer 142b can serve as a kind of an adhesive layer. For example, the core layer 142a can include Ni, Cu, Ag, Al, or the like as a main material (for example, a material containing 50 wt% or more, more specifically, a material containing 90 wt% or more). The solder layer 142b can include a solder material such as Pb, Sn, SnIn, SnBi, SnPb, SnPbAg, SnCuAg, SnCu, or the like as a main material. However, the present invention is not limited thereto, and the core layer 142a and the solder layer 142b can include various materials.

On the other hand, when the wiring member 142 is attached to the solar cell 150 by a tabbing process, as shown in FIG. 3, a shape of the solder layer 142b is changed in a part of the wiring member 142 attached to or connected to the solar cell 150.

More specifically, the wiring member 142 is attached to at least pad parts 422 and 442 by the solder layer 142b. At this time, the solder layer 142b of each wiring member 142 is individually positioned with other wiring member 142 or solder layer 142b. When the wiring member 142 is attached to the solar cell 150 by the tabbing process, each solder layer 142b flows down to the first or second electrodes 42, 44 (more specifically, the pad parts 422 and 424) as a whole during the tabbing process, and a width of the solder layer 142b can gradually increase toward the pad parts 422, 442 at a part adjacent to each pad part 422, 442 or a part positioned between the pad parts 422, 442 and the core layer 142a. As one example, the part adjacent to the pad parts 422 and 442 in the solder layer 142b can have a width equal to or greater than a diameter of the core layer 142a. At this time, the width of the solder layer 142b can be equal to or less than a width of the pad parts 422, 442.

More specifically, the solder layer 142b has a shape protruding toward the outside of the solar cell 150 along the shape of the core layer 142a in an upper part of the core layer 142a. On the other hand, the solder layer 142b includes a part having a concave shape with respect to the outside of the solar cell 150 in a lower part of the core layer 142a or a part adjacent to the pad parts 422 and 442. As a result, an inflection point where the curvature changes is positioned on the side of the solder layer 142b. It can be seen that the wiring member 142 are individually attached and fixed by the solder layer 142b without being inserted or covered in a separate layer, film, or the like from this shape of the solder layer 142b. The solar cell 150 and the wiring member 142 can be connected by a simple structure and a process by fixing the wiring member 142 by the solder layer 142b without using a separate layer or a film. Particularly, the wiring member 142 having a narrow width and a rounded shape as in the present embodiment can be attached without using a separate layer, a film, (for example, a conductive adhesive film including a resin and a conductive material) or the like, so that the process cost and time of the wiring member 142 can be minimized.

On the other hand, the part of the wiring member 142 positioned between the neighboring solar cells 150 (that is, outside the solar cell 150), which is not applied with heat or is applied with relatively less heat even after the tabbing process, can have a shape in which the solder layer 142b has a uniform thickness as shown in FIG. 4.

According to the present embodiment, optical loss can be minimized by diffused reflection or the like using a wire-shaped wiring material 142, and it is possible to reduce the movement path of the carrier by increasing the number of the wiring member 142 and reducing a pitch of the wiring member 142. In addition, the width or diameter of the wiring member 142 can be reduced, so that the material cost can be greatly reduced. Accordingly, the efficiency of the solar cell 150 and the output of the solar cell panel 100 can be improved.

Referring to FIG. 5 with FIGS. 1 to 4, an example of the electrodes 42 and 44 of the solar cell 150 to which the wiring member 142 according to an embodiment of the present invention is attached will be described in detail. Hereinafter, with reference to FIG. 5 the first electrode 42 will be described in detail, and for the second electrode 44, the same or similar parts as the first electrode 42 and the different parts from the first electrode 42 will be described.

FIG. 5 is a front plan view of the solar cell 150 included in the solar cell panel 100 according to the present embodiment.

Referring to FIGS. 1 to 5, in the present embodiment, the first electrode 42 includes a plurality of first finger lines 42a being extended in a first direction (an y-axis direction in the drawing) and positioned parallel to each other, and a first bus bar 42b formed in a second direction (an x-axis direction in the drawing) intersecting (for example, orthogonal) with the first finger line 42a and connected or attached to the wiring member 142. In the drawing, it is further formed a rim line 42c that connects the ends of the plurality of first finger lines 42a as a whole in the vicinity of both side edges. The rim line 42c can have the same or similar width as the first finger line 42a and can be composed of the same material as the first finger line 42a. However, it is also possible not to include the rim line 42c.

At this time, in the present embodiment, the solar cell 150 (or the semiconductor substrate 160) can be partitioned into an electrode area EA and an edge area PA. Here, the electrode area EA can be an area in which the first finger lines 42a formed in parallel to each other are arranged at a uniform pitch. The electrode area EA can include a plurality of electrode areas EA partitioned by the wiring member 142. The edge area PA is an area positioned between two adjacent electrode areas EA and positioned adjacent to an edge of the semiconductor substrate 160 or the solar cell 150 outside a plurality of first pad part 422 (particularly, first outer pads 424). At this time, the edge area PA can be an area where an electrode part 42d is positioned at a density lower than a density of the first finger line 42a of the electrode area EA, or an area where the electrode part 42d is not positioned. In the drawing, it is illustrated that the electrode parts 42d positioned on both sides of each other have the same shape. However, the present invention is not limited thereto, and various other modifications are possible.

In the present embodiment, at least a part of the plurality of first finger lines 42a include a contact part which is in direct contact with the first conductive type region 20, and serve to collect carriers generated by the photoelectric conversion from the first conductive type region 20. In one example, the plurality of first finger lines 42a can be extended in parallel to each other and spaced apart from each other so as to have a constant pitch.

In the present embodiment, the first bus bar 42b can include the plurality of first pad part 422 positioned in the second direction (the x-axis direction in the drawing) that intersects the first direction, and can further include a first line part 421 which is elongated with a relatively narrow width along a direction in which the wiring member 142 is connected. The first pad part 422 can improve the adhesion with the wiring member 142 and reduce the contact resistance, and the first line part 421 can minimize the optical loss. The first line part 421 can provide a path through which the carrier can bypass when some of the first finger lines 42a are broken. The wiring member 142 can be attached to the first line part 421, or the wiring member 142 can be placed on the first line part 421 in a state where the wiring member 142 is not attached to the first line part 421.

More specifically, the plurality of first pad parts 422 includes the outer pad 424 positioned to be adjacent to the edge of the semiconductor substrate 160 in the second direction, and a first inner pad 426 positioned inside the outer pad. Here, the outer pad 424 can mean two pads positioned to be closest to each of the two side edges when viewed in the second direction among the plurality of first pad parts 422, and the first inner pad 426 can mean a pad positioned between two first outer pads 424. Here, since the outer/inner reference is based on only the plurality of first pad parts 422, unlike the drawing, the first line part 421 can be positioned outside the first outer pad 424.

A width of the first pad part 422 in the first direction can be greater than a width of the first line part 421 in the first direction and a width of the first finger line 42a in the second direction, respectively. A length of the first pad part 422 in the first direction can be greater than the width of the first line part 421 in the first direction and the width of the first finger line 42a in the second direction, respectively. The width of the first line part 421 can be equal to or less than a width of the wiring member 142 and the width of the first pad part 422 can be equal to or greater than the width of the wiring member 142. As described above, if the first pad part 422 has a sufficient width, the first pad part 422 can improve the adhesion with the wiring member 142 and reduce the contact resistance. The width of the wiring member 142 can be less than a pitch of the first finger line 42a and can be greater than the width of the first finger line 42a. However, the present invention is not limited thereto and various modifications are possible.

At this time, a plurality of first inner pads 426 can be disposed at a predetermined interval in each first bus bar 42b. For example, 6 to 40 of the first inner pads 426 (for example, 12 to 24) can be disposed in the each first bus bar 42b. Here, each of the first inner pads 426 can be positioned for each of the plurality of first finger lines 42a, and for example, a pitch of the first inner pad 426 can be 2 to 20 times (for example, 3 times more, 10 times or less) the pitch of the first finger line 42a. However, the number, disposition, and the like of the first inner pads 426 can be variously modified. In FIG. 5, the first inner pads 426 are spaced at equal intervals, but the present invention is not limited thereto. Therefore, the number and density of the first inner pads 426 can be increased in a part where a large force acts.

In the present embodiment, the first outer pads 424 positioned at both ends of the first bus bar 42b of the first electrode 42 are formed to have a larger area (for example, a length) than the first inner pads 426. At this time, even if the widths of the first outer pads 424 determined in relation to the width (or the diameter) of the wiring member 142 are different from each other, they are not related to a contact area of the wiring member 142. Accordingly, the widths of the first outer pad 424 and the first inner pad 426 can be substantially the same in the first direction, and the length of the first outer pad 424 can be greater than the length of the first inner pad 426 in the second direction. Here, substantially the same can mean that they have an error of less than 5%, and a larger area or length can mean having a larger area or length of 5% or more (for example, 10% or more, for example, 20% or more).

The first outer pads 424 are positioned near both side edges of the semiconductor substrate 160 and are last parts in which the wiring member 142 is substantially attached inside the solar cell 150. Accordingly, whether the wiring member 142 is attached or not is determined based on the outer edge of the first outer pad 424, so thermal stress can be generated in the first outer pad 424 rather than the first inner pad 426. In consideration of this, the area of the first outer pad 424 can be larger than that of the first inner pad 426 in the present embodiment. Thereby, the attachment area of the first outer pad 424 to the wiring member 142 can be increased to maintain excellent attachment characteristics of the wiring member 142. Accordingly, defects of the solar cell panel 100 can be reduced, and reliability and productivity can be improved. In addition, the area of the first inner pad 426 having a relatively low problem in deterioration of the attachment characteristics of the wiring member 142 can be made relatively small, so that the area of the first electrode 42 can be reduced. However, the present invention is not limited thereto, and the first outer pad 424 can have an area (for example, a length) that is equal to or smaller than the first inner pad 426. Many other variations are possible.

Similarly, the second electrode 44 can include a second pad part 442, a second line part, or a second bus bar corresponding to the first pad part 422, the first line part 421, or the first bus bar 42b, and can further include a second finger line corresponding to the first finger line 42a of the first electrode 42. At this time, the width, pitch, thickness, etc. of the first finger line 42a, the first pad part 422 and the first line part 421 of the first electrodes 42 can be the same as or different from the width, pitch, thickness, etc. of the second finger line, the second pad part 442 and the second line part of the second electrodes 44. The first bus bar 42b and the second bus bar can be formed at the same position and can be formed in the same number. In addition, the second electrode 44 can further include a rim line and/or an electrode part corresponding to the rim line 42c and/or the electrode part 42d of the first electrode 42. If there is no other description, the content of the first electrode 42 can be applied to the second electrode 44 as is, and the content of the first insulating layer (the first passivation layer 22, anti-reflection layer 24, etc. formed on the front surface of semiconductor substrate 160) in relation to the first electrode 42 can be directly applied to a second insulating layer (the second passivation layer 32 formed on the back surface of the semiconductor substrate 160) in relation to the second electrode 44.

For example, in the present embodiment, the first or second finger lines 42a of the first or second electrodes 42 and 44 can be formed in contact with the first or second conductive type regions 20 and 30 through the insulating layer. The first or second bus bars 42b of the first or second electrodes 42 and 44 can be formed in contact with the first or second conductive type regions 20 and 30 through the insulating layer, or can be spaced apart from the first or second conductive type regions 20 and 30 on the insulating layer. At this time, in cross section, the structures of the first and second finger lines 42a and/or the first and second bus bars 42b in the first electrode 42 and the second electrode 44 can be the same or different from each other.

The solar cell panel 100 according to the present embodiment can have a structure that prevents damage to the solar cell 100 that can occur in the edge parts at which the thickness of the sealing member 130 can be less than that of other parts during the lamination process, in particular, in the bus ribbon part including the bus ribbon 145. This will be described in more detail with reference to FIGS. 6 and 7 with FIGS. 1 to 5.

FIG. 6 is a back plan view schematically illustrating the solar cell panel included in FIG. 1. FIG. 7 is a partial cross-sectional view of a solar cell panel showing an enlarged part of a solar cell panel shown in FIG. 1. For brief illustration and clear understanding, in FIG. 6, the wiring member 142 connecting two neighboring solar cells 150 shows only a part positioned outside the solar cell 150 and illustration of an insulating member 190 is omitted. In fact, the two neighboring solar cells 150 are connected as shown in FIG. 4 and the insulating member 190 can be positioned between a solar cell string SS and a bus ribbon part BSP.

Referring to FIG. 6 and FIG. 7, in the present embodiment, the bus ribbon part BSP including a bus ribbon 145 connected to the solar cell string SS and extending to the outside is positioned on one side (for example, an upper side) of the solar cell panel 100. Here, the bus ribbon part BSP can mean an area corresponding to a plurality of bus ribbons 145 connected to the solar cell string SS and extending to the outside of the solar cell panel 100. For example, the bus ribbon 145 of the bus ribbon part BSP can extend outside the back surface of the solar cell panel 100 and be connected to a terminal box (wiring box or junction box) 200 mounted (more specifically, mounted to be adjacent to one side, for example, the upper side of the solar panel 100) on the back surface of the solar cell panel 100.

Each bus ribbon 145 can include a main connecting part MP extending in a direction intersecting one or two neighboring solar cell strings SS and connected to the wiring member 142 connected to the solar cell 150 positioned at one end of the corresponding solar cell string SS and an extending part EP extending the main connecting part MP to a position adjacent to the terminal box 200.

At this time, the extending part EP of each bus ribbon 145 can have a shape that can minimize the area of the bus ribbon 145 or the bus ribbon part BSP. For example, an extending part EP of a first bus ribbon 145a positioned at both outer sides can extend along the first direction toward the terminal box 200 after being bent downward from the inner end of the main connecting part MP and then can be bent again to extend along the second direction to be connected to the terminal box 200. Then, it is possible to minimize the area of the bus ribbon part BSP while having a stable structure that prevents unwanted overlapping or short-circuit with a main connecting part MP of a second bus ribbon 145b positioned inside. An extending part EP of the second bus ribbon 145b positioned to be adjacent to the terminal box 200 at the inner side can be bent from an end adjacent to the terminal box 200 and extend along the second direction in the inside of the extending part EP of the first bus ribbon 145a to be connected to the terminal box 200. Then, the area of the bus ribbon part BSP can be minimized while having a stable structure which prevents an unwanted overlapping or short-circuit with the extending part EP of the first bus ribbon 145a.

At this time, in the present embodiment, the bus ribbon part BSP (for example, the extending part EP of the first and second bus ribbons 145a and 145b) can be positioned to overlap at least a part (for example, a part of solar cell 150 positioned at an end of one side) of the solar cell 150 positioned at one side (for example, upper side) of the solar cell panel 100 on the back surface of the solar cell 150. Then, the area of the solar cell panel 100 that is not involved in photoelectric conversion can be minimized while minimizing the area that the bus ribbon part BSP is recognized on the front surface. At this time, the insulating member 190 can be positioned to prevent unwanted electrical connection between the solar cell string SS including the solar cell 150 and the bus ribbon part BSP.

The insulating member 190 can be formed to correspond to the solar cell 150 positioned at each upper side, and have a shape extending in the second direction (y-axis direction of the drawing) to be positioned over the plurality of solar cell strings SS. The insulating member 190 can include various known insulating materials (for example, resin), and can be formed in various forms such as a film and a sheet. For example, the insulating member 190 can include an insulating part 190a and an adhesive layer 190b formed on at least one surface thereof. The insulating part 190a can use various insulating materials. The adhesive layer 190b can use various known materials. For example, the same material as the first sealing member 131 or the second sealing member 132 can be used. Then, the stability can be improved by having the same or similar characteristics as the first sealing member 131 or the second sealing member 132.

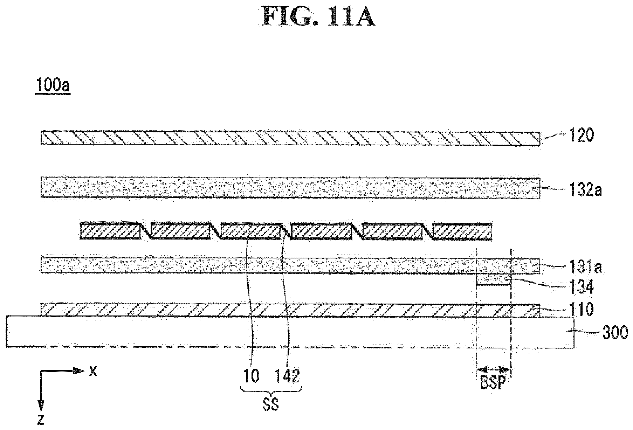

In the present embodiment, at least one of the first and second sealing members 131 and 132 can be provided with an additional sealing part ASP in a part corresponding to the bus ribbon part BSP. This additional sealing part ASP can be formed by further using an additional sealing member (reference numeral 134 in FIG. 11A, the same below) partially positioned during the lamination process. This will be described later in detail with reference to FIGS. 11A through 11C in the method for manufacturing the solar cell panel 100. The additional sealing member 134 can be made of the same material as a first and/or second main sealing member (reference numerals 131a and 132a in FIG. 11A, the same below) that is formed as a whole, or can be provided of a different material. If the additional sealing member 134 is a different material from the first and/or second main sealing members 131a and 132a, it can be easily determined or defined by that the first and/or second sealing members 131, 132 after the lamination process have a different material from that formed entirely.

In the present embodiment, the additional sealing part ASP can be a part having a thicker thickness than the other parts of the first and/or second sealing members 131 and 132, as shown in FIG. 7. Here, a thickness of the first sealing member 131 can mean a distance between the solar cell 150 (such as, for example, any part of the solar cell 150 to the first cover member 110, including a most proximate surface of the solar cell 150 to the first cover member 110) and the first cover member 110, and a thickness of the second sealing member 132 can mean a distance between the solar cell 150 (such as, for example, any part of the solar cell 150 to the second cover member 120, including a most proximate surface of the solar cell 150 to the second cover member 120) and the second cover member 120. If the additional sealing member 134 is positioned in a part corresponding to the bus ribbon part BSP during the lamination process, a thickness of a part in which the bus ribbon part BSP is positioned can be thicker than other pats in the corresponding part. Then, the part having a thickness thicker than the other part can be determined or defined as the additional sealing part ASP or a part in which the additional sealing member 134 is positioned. For example, if the thickness of the first and/the second sealing member 131, 132 that is greater (for example, large parts with a difference of 5% or more) than the other part is provided by measuring the thickness of the first and/or second sealing member 131, 132, it can be determined that the additional sealing member 134 or the additional sealing part ASP is provided, and the position, size, and the like of the additional sealing member 134 or the additional sealing part ASP can be determined or defined from the position and size of the part having a greater thickness than the other parts. When the additional sealing part ASP is thicker than the other parts of the first and/or second sealing members 131 and 132, as shown in FIG. 7, the additional sealing part ASP that is thicker can be curved section or a bulged section in the sealing member 130, such as the first sealing member 131. Also, when the additional sealing part ASP is thicker than the other parts of the first and/or second sealing members 131 and 132, as shown in FIG. 7, a corresponding portion of the first cover member 110 can accommodate the additional sealing part ASP being thicker, for example, by having a curvature or a bulge.

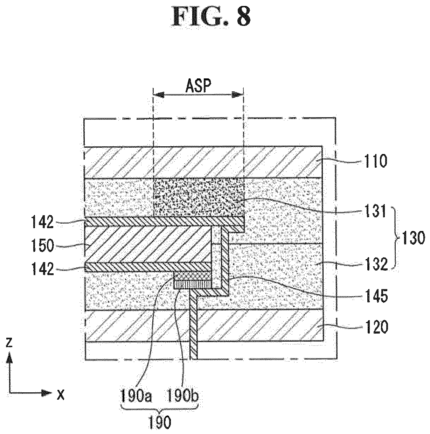

However, the present invention is not limited thereto. Accordingly, the thicknesses of the first and second sealing members 131 and 132 can be changed together at the corresponding parts by the additional sealing member 134. In addition, as shown in FIG. 8, even when the additional sealing member 134 is provided in the lamination process, the thickness in the corresponding part does not change and the density in the corresponding part can be higher than in other parts. The part having a higher density than the other part can be determined as the part in which the additional sealing part ASP or the additional sealing member 134 is positioned. For example, by measuring the density of the first and/or second sealing members 131, 132, when the part where the density of the first and/or second sealing members 131 and 132 is greater than the other parts (for example, a large part with a difference of 5% or more) are provided, it can be determined that the additional sealing member 134 or the additional sealing part ASP is provided, and the position, size, etc. of the additional sealing member 134 or the additional sealing part ASP can be determined or defined from the position and size of the part having a greater density than the other parts.

As another example, an additional sealing part ASP having a higher thickness and higher density than another part can be positioned in a part corresponding to the additional sealing member 134. As another example, even when the additional sealing member 134 is provided separately, a separate additional sealing part ASP having a change or difference in thickness or density is not formed, and the first and/or second sealing members 131 and 132 can have the same thickness. Since the part where the bus ribbon part BSP is positioned is a part where a lot of or greater pressure is applied and the thickness of the sealing members 131 and 132 can be thinner than other parts, even if the additional sealing member 134 is provided, it may not be possible to increase the thickness and/or density of the first and/or second seals 131, 132 by being disposed to reinforce the thickness of the first and/or second seals 131, 132. Many other variations are possible.

Referring to FIG. 6 to FIG. 8, in the present embodiment, the sealing member (for example, the first sealing member 131) disposed so as to be opposite to the insulating member 190 among the first and second sealing members 131 and 132 can include the additional sealing part ASP having a greater thickness or a greater density than the other parts in the part corresponding to the bus ribbon part BSP. The additional sealing part ASP is positioned so as to include the entire part where the bus ribbon part BSP is positioned in the solar cell panel 100, but can be partially positioned in a part corresponding to the bus ribbon part BSP based on the solar cell panel 100.

In the present embodiment, the additional sealing part ASP or the additional sealing member 134 can have a straight or rectangular shape covering a total width and a total length of the bus ribbon part BSP as shown in FIG. 6. Here, the total width and the total length of the bus ribbon part BSP can mean a width and a length between both ends positioned at the outermost side of the bus ribbon part BSP. For example, a ratio of a width of the additional sealing part ASP to the total width of the bus ribbon part BSP can be 1 to 1.5 (for example, 1 to 1.2, more specifically 1 to 1.1), and a ratio of a length of the additional sealing part ASP to the total length of the bus ribbon part BSP can be between 1 and 1.5 (for example, 1 to 1.2, more specifically 1 to 1.1). By such a shape and numerical range, while simplifying the shape of the additional sealing member 134, the amount of the additional sealing member 134 can be reduced to reduce the costs. Also, a width of the additional sealing part ASP in a direction (such as an x-axis direction) can be the same along a length of the additional sealing part ASP in another direction (such as a y-axis direction).

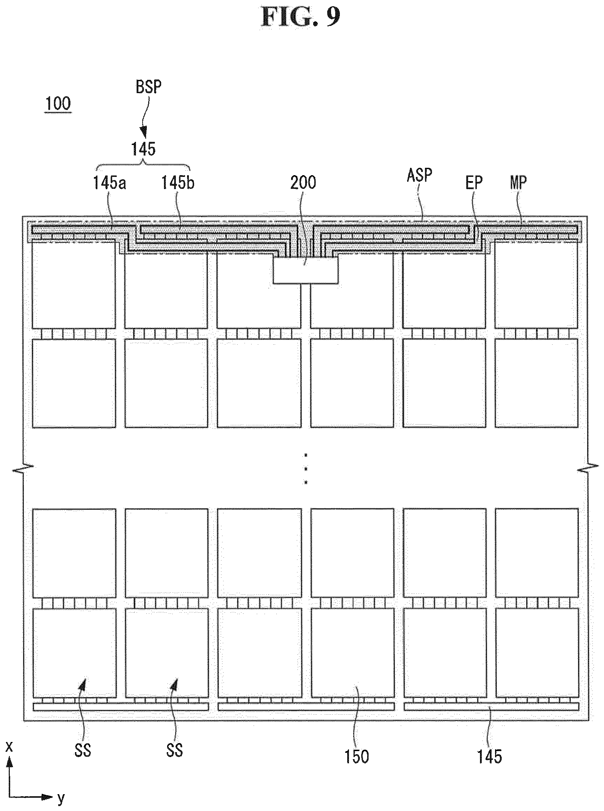

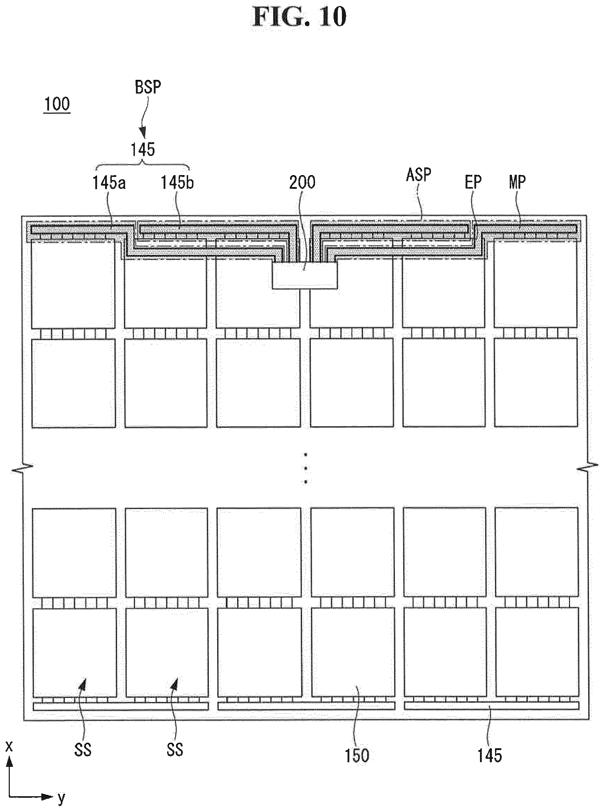

However, the present invention is not limited thereto. For example, as shown in FIG. 9, the additional sealing part ASP or the additional sealing member 134 can have an outer shape similar to that of the bus ribbon part BSP. That is, the additional sealing part ASP or the additional sealing member 134 can be formed so as to correspond to the length between both ends of the bus ribbon part BSP in each part when viewed in each of the first and second directions. Accordingly, the ratio of the length of the additional sealing part ASP to the length between both ends can be between 1 and 1.5 (for example, 1 to 1.2, more specifically 1 to 1.1) in each part of the additional sealing portion ASP or the additional sealing member 134 when viewed in each of the first and second directions. By such a shape and numerical range, the amount of the additional sealing member 134 can be further reduced to reduce the costs. For example, the width of the additional sealing part ASP in a direction (such as the x-axis direction) can be different along the length of the additional sealing part ASP in another direction (such as the y-axis direction) so that the width of the width of the additional sealing part ASP is narrower at opposite ends. As another example, as shown in FIG. 10, the additional sealing part ASP or the additional sealing member 134 can include a plurality of parts formed separately to correspond to each bus ribbon 145 constituting the bus ribbon part BSP. That is, in the embodiment of FIG. 9, the additional sealing part ASP or the additional sealing member 134 is positioned to fill all of the plurality of bus ribbons 145 and the space therebetween in the part where the plurality of bus ribbons 145 are provided when viewed at a point in the width direction, on the other hand, in another example, the additional sealing portion ASP or the additional sealing member 134 can be positioned to have a part or parts covering the plurality of bus ribbons 145 individually, but not covering the space between the plurality of bus ribbons 145 in the part where the plurality of bus ribbons 145 are provided when viewed at a point in the width direction. For example, the additional sealing member 134 can have spaces between various parts thereof, or parts of the additional sealing member 134 can be separated from each other. Many other variations are possible.

In the present embodiment the additional sealing part ASP is positioned to be spaced apart from the edge of the solar cell panel 100 in a plan view, so that it can reduce the amount of additional sealing member 134 for forming the additional sealing part ASP and improve stability.

For reference, since the part (that is, the lower part) where the bus ribbon 145, which does not extend to the outside, is positioned is not largely change in the thickness of the solar cell string (SS), there may not be the additional sealing part ASP or the additional sealing member 134 therein. This can reduce the amount of the additional sealing part ASP or the additional sealing member 134 and simplify the structure.

As described above, the part where the bus ribbon part BSP is positioned is a part where the thickness of the sealing member 130 can be thinner than other part, and in the present embodiment, an additional sealing part ASP is positioned in this part by performing the lamination process in a state where the additional sealing member 134 is positioned to increase the thickness of the sealing member 130 or to reinforce the sealing member 130 in this part. Thus, even if a temperature cycle test for changing repeatedly the temperature is performed on the solar cell panel 100, cracks occur in the solar cell 150 in the part where the bus ribbon part BSP is positioned, or thereby, grid interruption caused by soldering (GICS) occurs, thereby lowering the output of the solar cell 150. Thus, it is possible to prevent the output of the solar cell 150 from being lowered. Accordingly, it is possible to prevent the solar cell 150 from being damaged at the edge part of the solar cell panel 100. This effect can be especially doubled in a structure in which the wiring member 142 includes a circular shape or a rounded part, have a relatively large thickness (for example, a thickness substantially equal to the width, for example, 1 mm or less) compared to the width (for example, 1 mm or less), or the first and second cover members 110 and 120 each have a glass substrate in particular, as in the present embodiment.

In particular, in the present embodiment, the first and second cover members 110 and 120 each include the glass substrate, and the thickness of the sealing member 130 (that is, first or second sealing members 131, 132) positioned on one side of the solar cell 150 can be twice or less with respect to a width or a diameter of a first wiring member 1421. Here, the thickness of the sealing member 130 positioned on one side of the solar cell 150 can mean a thinnest thickness as a distance between the solar cell 150 and the first or second cover member 110 and 120. When the first and second cover members 110 and 120 each use the glass substrate, various characteristics of the solar panel 100 can be improved due to the excellent durability, insulation, and light transmittance of the glass substrate, and the output can be improved by the bi-facial light receiving structure. In addition, when the first or second sealing members 131 and 132 having the above-described thickness are used, the process cost can be reduced and the weight of the solar cell panel 100 can be reduced. On the other hand, since the first or second sealing members 131 and 132 are difficult to be made to have a predetermined thickness or more, in order to increase the thickness, one sealing member 131 and 132 must be provided in a plurality of layers, thereby greatly increasing the process cost. Accordingly, the weight of the solar cell panel 100 can also increase significantly. Accordingly, in the present embodiment, the first or second sealing members 131 and 132 can be formed to have a predetermined thickness or less to reduce the number or thickness of layers constituting the sealing member 130. In this case, damage to the solar cell 150, which can occur in the bus ribbon part BSP, can be effectively prevented by the additional sealing member 134 or the additional sealing part ASP.

Hereinafter, a method for manufacturing the solar panel 100 according to the present embodiment will be described in detail with reference to FIGS. 11A to 11C.

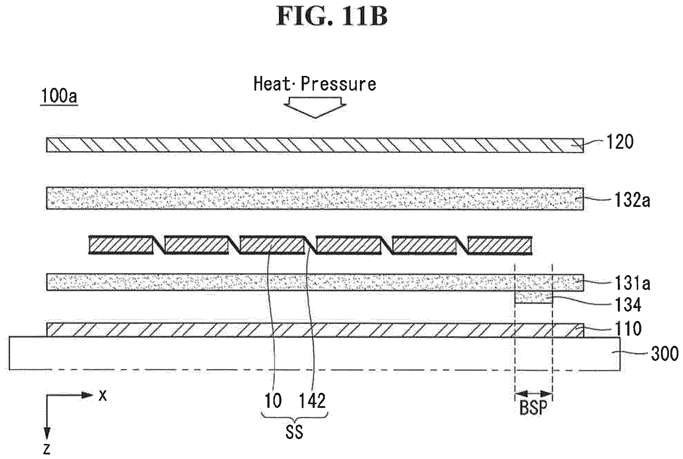

FIGS. 11A to 11C are diagrams schematically illustrating a method for manufacturing the solar cell panel 100 according to an embodiment of the present invention. For clear understanding and explanation. FIGS. 11A to 11C illustrate the bus ribbon part BSP only or schematically as an area, and detailed illustrations of the bus ribbon 145 and the like are omitted. FIGS. 11A and 11B illustrate members constituting a stacked structure 100a to be spaced apart from each other for clarity of understanding, but they can actually be positioned in contact with each other.

First, as shown in FIG. 11A, in a stacking process, a stacked structure 100a in which a first cover member 110 on a work table 300 of a lamination device, a first main sealing member 131a formed as a whole and having a uniform thickness, a solar cell string SS and a bus ribbon part BSP connected to the solar cell string SS, a second main sealing member 132a formed as a whole and having a uniform thickness, and a second cover member 120 are stacked is stacked. At this time, an additional sealing member 134 can be further positioned at a part corresponding to the bus ribbon part BSP between the first cover member 110 and the second cover member 120. Although the drawing illustrates that the first cover member 110 is positioned on the work table 300, the reverse is also possible.

At this time, the additional sealing member 134 can be positioned on an opposite side to an insulating member 190 positioned between the solar cell string SS and the bus ribbon part BSP (that is, the back surface of the solar cell string SS) in the solar cell string SS. For example, the additional sealing member 134 can be positioned between the solar cell string SS and the first cover member 110. In the drawing, the additional sealing member 134 can be positioned between the first main sealing member 131a and the first cover member 110 to effectively prevent a thickness of a sealing member 130 from becoming thin at the corresponding part. However, the present invention is not limited thereto, and the additional sealing member 134 can be positioned between the first main sealing member 131a and the solar cell string SS. Alternatively, the additional sealing member 134 can be positioned between the first main sealing member 131a and the first cover member 110 and between the first main sealing member 131a and the solar cell string SS respectively. As another example, the additional sealing member 134 can be positioned between the solar cell string SS and the second cover member 120. In this case, the additional sealing member 134 can be positioned between the second main sealing member 132a and the second cover member 120 and/or between the second main sealing member 132a and the solar cell string SS, respectively. As another example, the additional sealing member 134 can be positioned between the solar cell string SS and the second cover member 120 and between the solar cell string SS and the second cover member 120, respectively.

Here, a ratio of the thickness of the additional sealing member 134 to the thickness of the first or second main sealing member 131a, 132a can be 0.4 to 1.5 times. Alternatively, the thickness of the additional sealing member 134 can be 250 µm to 600 µm or approximately 250 µm to 600 µm. Within this range, the cost can be reduced while improving the effect of the additional sealing member 134 and structural stability can be improved.

As an example, the thickness of the additional sealing member 134 can be the same as the thickness of the first or second main sealing member 131a and 132a. Then, the first or second main sealing member 131a and 132a can be cut into a desired size and used as the additional sealing member 134, thereby improving mass productivity. Alternatively, the thickness of the additional sealing member 134 can be greater than the thickness of the first or second main sealing member 131a and 132a. Then, the long-term reliability can be improved by maximizing the effect by the additional sealing member 134. Alternatively, the thickness of the additional sealing member 134 can be smaller than the thickness of the first or second main sealing member 131a and 132a. Then, the thickness of the additional sealing member 134 can be reduced to reduce the cost of the additional sealing member 134.

FIGS. 11A and 11B illustrate that the additional sealing member 134 has a separate structure from the first or second main sealing member 131a and 132a to be placed on or attached thereto. However, the present invention is not limited thereto. Accordingly, the additional sealing member 134 and the first or second main sealing member 131a and 132a can have a single body integrated, and various other modifications are possible.

In the present embodiment, the additional sealing member 134 can be made of the same material as the first or second main sealing member 131a and 132a, or can be made of a different material from those of the first or second main sealing member 131a and 132a. When the additional sealing member 134 and the first or second main sealing member 131a and 132a include different materials, the additional sealing member 134 and the first or second main sealing member 131a and 132a can be formed of materials capable of maximizing the cushioning action of the additional sealing member 134. For example, the additional sealing member 134 can have a lower hardness and higher elasticity than the first or second main sealing member 131a and 132a to maximize the cushioning action. However, the present invention is not limited thereto. In embodiments of the present invention, the additional sealing member 134 can be made of a combination of the same and different materials from those of the first or second main sealing member 131a and 132a, and such a combination can be lamination of the same and different materials in different layers through the thickness of the additional sealing member 134. Alternatively or additionally, in such a combination, respective thicknesses of the same and different materials in different layers can be the same or different. Additionally, instead of each layer being the same material in the combination, each layer can be formed of different material in different parts so that one portion of the layer can have one material and another portion of the layer can have another material. Alternatively or additionally, the additional sealing member 134 corresponding to the first bus ribbon 145a can be different from the additional sealing member 134 corresponding to the second bus ribbon 145b. Alternatively or additionally, a material for the additional sealing member 134 at the extending part EP can be different from a material for the additional sealing member 134 at the main connection part MP. Other variations in the additional sealing member 134 in terms of material, coverage, dimensions and shapes, for example, are possible.

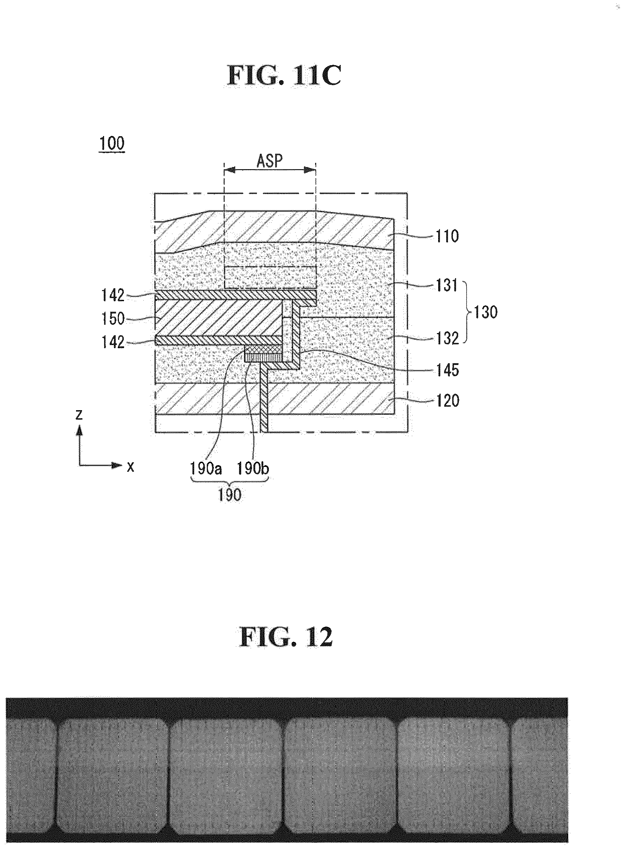

Then, as shown in FIG. 11B, in the lamination process, a stacked structure 100a in which the first cover member 110, the additional sealing member 134, the first main sealing member 131a, the solar cell string SS and the bus ribbon part BSP connected to the solar cell string SS, the second main sealing member 132a formed as a whole and having a uniform thickness, and the second cover member 120 are stacked is stacked by applying heat and pressure. That is, the solar cell 150 can be sealed while the sealing member 130 completely fills the space between the first cover member 110 and the second cover member 120 which is hardened after the additional sealing member 134, the first main sealing member 131a, and the second main sealing member 132a are melted and compressed by pressure, at a high temperature of the lamination process. As a result, the space between the first cover member 110 and the second cover member 120 can be completely filled by the sealing member 130. Thereby, the solar cell panel 100 which has a structure as shown in FIG. 11C is manufactured in the part including the bus ribbon part BSP.

According to the present embodiment, damage to the solar cell 150, which can occur near the edge (for example, near the upper edge) of the solar cell panel 100 where the bus ribbon part BSP is positioned, can be effectively prevented by a simple structure using the additional sealing member 134. Thereby, the long-term reliability of the solar cell panel 100 can be improved while the solar cell panel 100 is manufactured by a simple process. At this time, since the additional sealing member 134 is partially provided corresponding to the bus ribbon part BSP, the cost can be effectively reduced. This effect can be especially doubled in a structure in which the thickness of the sealing member is below a certain level, the wiring member has a relatively large thickness as compared with the width, or the wiring member has a circular shape or a rounded shape, or the first and second cover members 110 and 120 each include a glass substrate.

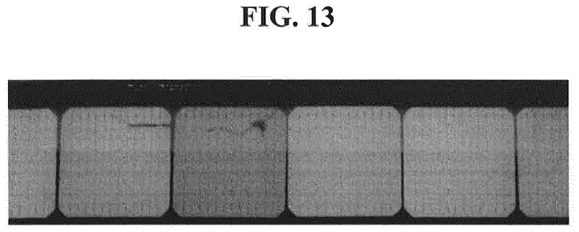

FIG. 12 attaches a photographic image of a solar cell panel including a sealing member having an additional sealing part or an additional sealing member as in an embodiment of the present invention, and FIG. 13 attaches a photographic image of a solar cell panel according to a comparative example including a sealing member having no additional sealing part or no additional sealing member unlike the present invention. The solar cell panel shown in FIGS. 12 and 13 are photographic images after performing the temperature cycle test for the same time under the same conditions, and in examples and comparative examples, all other conditions are the same except for whether the additional sealing part or the additional sealing member is provided.

In the solar cell panel according to an embodiment of the present invention as shown in FIG. 12, the cracking phenomenon of the solar cell does not occur in the upper end part where the bus ribbon part is positioned, but in the solar cell panel according to the comparative example as shown in FIG. 13, it can be seen that the cracking phenomenon of the solar cell occurs in the upper end part of the solar cell where the bus ribbon part is positioned. From this, it can be seen that the cracking phenomenon of the solar cell can be prevented in the lamination process and the temperature cycle test by providing the additional sealing part or the additional sealing member.

The features, structures, effects and the like according to the above-described embodiments are included in at least one embodiment of the present invention, and are not necessarily limited to only one embodiment. Furthermore, the features, structures, effects, and the like illustrated in the embodiments can be combined or modified in other embodiments by those skilled in the art to which the embodiments belong.

## Claims

1. A method for manufacturing a solar cell panel (100), the method comprising:
forming a stacked structure (100a) by stacking a first cover member (110), a first main sealing member (131a), a solar cell string (SS) including a plurality of solar cells (150) and a plurality of wiring members (142) connecting the plurality of solar cells (150) in one direction, a bus ribbon part (BSP) including a bus ribbon (145) connected to the solar cell string (SS) and extending outwards towards a periphery of the solar cell panel (100), a second main sealing member (132a), and a second cover member (120); and
laminating the stacked structure (100a) by applying heat and pressure to the stacked structure (100a),
wherein, in the forming the laminate structure (100a), an additional sealing member (134) is further positioned in a part of the stacked structure (100a) corresponding to the bus ribbon part (BSP) between the first cover member (110) and the second cover member (120), and
wherein each of the first and second cover members (110, 120) is a glass substrate, **characterized in that**:
an insulating member (190) is provided between the solar cell string (SS) and the bus ribbon part (BSP) in a part where the bus ribbon (145) is overlapping at least a part of the solar cell string (SS) to insulate the bus ribbon (145) from the at least a part of the solar cell string (SS), and
the additional sealing member (134) is positioned opposite to the insulating member (190) with respect to the solar cell string (SS) and between the first cover member (110) and the first main sealing member (131a).

2. The method of claim 1, wherein a ratio of a thickness of the additional sealing member (134) to a thickness of the first or second main sealing member (131a, 132a) is 0.4 times to 1.5 times.

3. The method of claim 1 or 2, wherein a thickness of the additional sealing member (134) is equal to, greater than or less than a thickness of the first or second main sealing member (131a, 132a).

4. The method of any one of claims 1 to 3, wherein a thickness of the additional sealing member (134) is 250 µm to 600 µm.

5. The method of any one of claims 1 to 4, wherein the additional sealing member (134) is formed of a different material from that of the first (131a) and second (132a) main sealing members.

## Patentansprüche

1. Verfahren zur Herstellung einer Solarzellentafel (100), wobei das Verfahren umfasst:
Bilden einer Stapelstruktur (100a) durch Stapeln eines ersten Abdeckelements (110), eines ersten Hauptdichtungselements (131a), einer Solarzellenkette, SS, einschließlich einer Mehrzahl von Solarzellen (150) und einer Mehrzahl von Verdrahtungselementen (142), die die Mehrzahl von Solarzellen (150) in einer Richtung verbindet, eines Sammelschienenteils, BSP, einschließlich einer Sammelschiene (145), die mit der Solarzellenkette, SS, verbunden ist und sich nach außen zu einem Umfang der Solarzellentafel (100) erstreckt, eines zweiten Hauptdichtungselements (132a) und eines zweiten Abdeckelements (120); und
Laminieren der Stapelstruktur (100a) durch Anwenden von Wärme und Druck auf die Stapelstruktur (100a),
wobei beim Bilden der Laminatstruktur (100a) ferner ein zusätzliches Dichtungselement (134) in einem Teil der Stapelstruktur (100a) entsprechend dem Sammelschienenteil, BSP, zwischen dem ersten Abdeckelement (110) und dem zweiten Abdeckelement (120) positioniert ist und
wobei sowohl das erste als auch das zweite Abdeckelement (110, 120) ein Glassubstrat ist,
**dadurch gekennzeichnet, dass**:
ein Isolierelement (190) zwischen der Solarzellenkette, SS, und dem Sammelschienenteil, BSP, in einem Teil vorgesehen ist, in dem die Sammelschiene (145) zumindest einen Teil der Solarzellenkette, SS, überlappt, um die Sammelschiene (145) von zumindest einem Teil der Solarzellenkette, SS, zu isolieren, und
das zusätzliche Dichtungselement (134) gegenüber dem Isolierelement (190) in Bezug auf die Solarzellenkette, SS, und zwischen dem ersten Abdeckelement (110) und dem ersten Hauptdichtungselement (131a) positioniert ist.

2. Verfahren nach Anspruch 1, wobei ein Verhältnis einer Dicke des zusätzlichen Dichtungselements (134) zu einer Dicke des ersten oder zweiten Hauptdichtungselements (131a, 132a) das 0,4-fache bis 1,5-fache beträgt.

3. Verfahren nach Anspruch 1 oder 2, wobei eine Dicke des zusätzlichen Dichtungselements (134) gleich, größer oder kleiner als eine Dicke des ersten oder zweiten Hauptdichtungselements (131a, 132a) ist.

4. Verfahren nach einem der Ansprüche 1 bis 3, wobei eine Dicke des zusätzlichen Dichtungselements (134) 250 µm bis 600 µm beträgt.

5. Verfahren nach einem der Ansprüche 1 bis 4, wobei das zusätzliche Dichtungselement (134) aus einem anderen Material als jenes des ersten (131a) und des zweiten (132a) Hauptdichtungselements gebildet ist.

## Revendications

1. Procédé de fabrication d'un panneaux de cellules solaires (100), le procédé consistant à:
former une structure empilée (100a) par empilement d'un premier élément de recouvrement (110), un premier élément isolant principal (131a), une chaîne de cellules solaires (SS) comprenant une pluralité de cellules solaires (150) et une pluralité d'éléments de câblage (142) connectant la pluralité des cellules solaires (150) dans une direction, une partie ruban de barre omnibus (BSP) comprenant un ruban de barre omnibus (145) connecté à la chaîne de cellules solaires (SS) et s'étendant vers l'extérieur dans la direction d'une périphérie du panneau de cellules solaires (100), un second élément isolant principal (132a), et un second élément de recouvrement (120); et
stratifier la structure empilée (100a) par application de chaleur et de pression à la structure stratifiée (100a),
dans lequel, lors de la formation de la structure stratifiée (100a), un élément isolant supplémentaire (134) est en outre positionné dans une partie de la structure empilée (100a) correspondant à la partie ruban de barre omnibus (BSP) entre le premier élément de recouvrement (110) et le second élément de recouvrement (120), et
dans lequel les premier et le second éléments de recouvrement (110, 120) est un substrat de verre, **caractérisé en ce que**:
un élément isolant (190) est disposé entre la chaîne de cellules solaires (SS) et la partie ruban de barre omnibus (BSP) dans une partie où le ruban de barre omnibus (145) recouvre au moins une partie de la chaîne de cellules solaires (SS) pour isoler le ruban de barre omnibus (145) forment l'au moins une partie de la chaîne de cellules solaires (SS), et
l'élément d'étanchéité supplémentaire (134) est positionné en regard de l'élément isolant (190) par rapport à la chaîne de cellules solaires (SS) et entre le premier élément de recouvrement (110) et le premier élément isolant principal (131a).

2. Procédé selon la revendication 1, dans lequel un rapport entre une épaisseur de l'élément isolant supplémentaire (134) et une épaisseur des premier et second éléments isolants (131a, 132a) est de 0,4 fois à 1,5 fois.

3. Procédé selon la revendication 1 ou 2, dans lequel une épaisseur de l'élément isolant supplémentaire (134) est égale, supérieure ou inférieure à une épaisseur des premier et second éléments isolants (131a, 132a).

4. Procédé selon l'une quelconque des revendications 1 à 3, dans lequel une épaisseur de l'élément isolant supplémentaire (134) est comprise entre 250 µm et 600 µm.

5. Procédé selon l'une quelconque des revendications 1 à 4, l'élément isolant supplémentaire (134) est formé d'un matériau différent de celui des premier (131a) et second (132a) éléments isolants principaux.
